# EUROPÄISCHE PATENTSCHRIFT

(11) **EP 0 852 807 B1**
(45) Veröffentlichungstag und Bekanntmachung des Hinweises auf die Patenterteilung: **06.01.2010**
(21) Anmeldenummer: 96937189.7
(22) Anmeldetag: 19.09.1996
(51) Int. Cl.: H01L 21/607

(54) **VERFAHREN ZUM ELEKTRISCHEN VERBINDEN EINES HALBLEITERCHIPS MIT ZUMINDEST EINER KONTAKTFLÄCHE**
METHOD OF ELECTRICALLY CONNECTING A SEMICONDUCTOR CHIP TO AT LEAST ONE CONTACT SURFACE
PROCEDE DE CONNEXION ELECTRIQUE D'UNE PUCE A SEMI-CONDUCTEUR AVEC AU MOINS UNE SURFACE DE CONTACT

(30) Priorität: 26.09.1995 DE 19535775
(43) Veröffentlichungstag der Anmeldung: 15.07.1998
(73) Patentinhaber: Infineon Technologies AG, 81669 München (DE)
(72) Erfinder: HEITZER, Josef, D-93090 Bach (DE); KIRSCHBAUER, Josef, D-93476 Blaibach (DE); STAMPKA, Peter, D-92421 Schwandorf-Klardorf (DE)
(74) Vertreter: Schweiger, Martin
(86) Internationale Anmeldenummer: PCT/DE1996/001783
(87) Internationale Veröffentlichungsnummer: WO 1997/012394

(56) Entgegenhaltungen:
- EP-A- 0 211 360
- EP-A- 0 320 244
- EP-A- 0 397 426
- US-A- 5 299 729
- PATENT ABSTRACTS OF JAPAN vol. 017, no. 110 (E-1329), 8.März 1993 & JP 04 294552 A (MATSUSHITA ELECTRON CORP), 19.Oktober 1992,
- PATENT ABSTRACTS OF JAPAN vol. 011, no. 343 (E-555), 10.November 1987 & JP 62 123727 A (HITACHI LTD), 5.Juni 1987,
- PATENT ABSTRACTS OF JAPAN vol. 010, no. 170 (E-412), 17.Juni 1986 & JP 61 023329 A (NIPPON DENKI KK), 31.Januar 1986,

## Beschreibung

Die Erfindung betrifft ein Verfahren zur elektrischen Verbindung eines Halbleiterchips mit zumindest einer Kontaktfläche mittels eines dünnen Drahtes, dessen erstes Ende mit der zumindest einen Kontaktfläche und dessen zweites Ende mit einem auf einem Kontaktfeld des Halbleiterchips angeordneten und mit diesem leitend verbundenen Metallstück verschweißt ist.

Solche Verfahren werden in bekannter Weise durch Bonden durchgeführt. Es ist dabei üblich, den meistens etwa 24 µm dicken Golddraht in einer Kapillare zu führen, an deren Ende er ein Stück heraussteht. Mittels einer Wasserstoffflamme oder eines elektrisch gezündeten Funkens wird das herausstehende Stück geschmolzen, so daß es sich zu einer kleinen Kugel, dem sogenannten ball formt. Diese Kugel wird nun mittels der Kapillare auf eine erste Kontaktfläche gedrückt und dabei durch Vibrationen der Kapillare im Ultraschallbereich mit der Kontaktfläche verbunden, wobei eine als nailhead bezeichnete Form des Golddrahtes entsteht. Beim sogenannten thermo-sonic-Bonden wird zusätzlich die Kontaktfläche auf eine Temperatur von etwa 200° C bis 300° C aufgeheizt. Danach wird die Kapillare wieder nach oben bewegt und in einem Bogen, dem sogenannten loop, zu einer zweiten Kontaktfläche, die mit der ersten Kontaktfläche verbunden werden soll, geführt. Dort senkt sich die Kapillare wieder ab und quetscht den Golddraht auf der zweiten Kontaktfläche ab. Durch den relativ hohen Druck entsteht eine gute Verbindung des Golddrahts mit der zweiten Kontaktfläche, wobei sich eine als wedge bezeichnete keilförmige Struktur ergibt. Diese Art des Bondens wird auch ballwedge-Bonden genannt, im Gegensatz zum wedge-wedge-Bonden, wie es bei Aluminiumdrähten üblich ist.

Bei der Verbindung von Halbleiterchips mit Kontaktflächen wird meistens der ball mit dem Halbleiterchip und der wedge mit der Kontaktfläche verbunden, da der ball besser plaziert werden kann und der daraus resultierende nailhead eine genauer definierte Größe hat als der wedge. Außerdem ist die Gefahr, Strukturen auf dem Halbleiterchip zu zerstören, beim ball-on-chip-Verfahren sehr gering. Den Nachteil dieses Vorgehens ist jedoch, daß der loop relativ groß ausfällt, was jedoch bei den üblichen Halbleitergehäusen keine Rolle spielt.

Beispielsweise bei Chipkarten ist die Gehäusehöhe, die der Dicke der Chipkarte entspricht, jedoch sehr klein und fest vorgegeben. Wird dort eine Komponente, beispielsweise der Träger, etwas dicker ausgeführt, muß dieser zusätzliche Platzbedarf an anderer Stelle wieder eingespart werden.

Aus der DE 36 21 917 A1 ist es bekannt, den Draht zuerst mit einer Kontaktfläche und dann mit dem Halbleiterchip zu verbinden. Da durch diese Vorgehensweise der nailhead-Kontakt auf der Kontaktfläche und der wedge-Kontakt auf das Kontaktfeld des Halbleiterchips kommt, entsteht eine geringe loop-Höhe. Allerdings besteht aufgrund des flachen Winkels, in dem der Draht auf das Kontaktfeld des Chips geführt wird, die Gefahr eines Kurzschlusses mit der Chipoberfläche. Außerdem ist der Goldanteil in der Fügezone Gold/Aluminium (Kontaktfelder der Halbleiterchips bestehen üblicherweise aus Aluminium) deutlich geringer als bei einem nailhead-Kontakt. Dadurch wird das Gold nachweislich vollständig in spröde intermetallische Phasen umgesetzt, so daß es zu Kontaktablösung bzw. Kontaktisolierung kommt.

Eie EP 0 397 426 A2 offenbart eine Anordnung, bei der vor dem Anbringen eines wedge-Kontaktes auf einer Kontaktfläche des Halbleiterchips ein nailhead-Kontakt auf diese Kontaktfläche aufgebracht wird und der wedge-Kontakt erst auf diesen nailhead-Kontakt kommt. Dadurch wird die Zuverlässigkeit der Verbindung erhöht.

Der nailhead-Kontakt liefert die gleichen metallurgischen Verhältnisse wie beim traditionellen thermo-sonic-nailhead-Kontaktieren.

Allerdings kann es durch die flache Führung des Bonddrahtes über der Chipoberfläche, insbesondere wenn das Kontaktfeld im Innenbereich der Chipoberfläche liegt, zu einem Kontakt des Bonddrahtes mit der Kante des Halbleiterchips kommen, was zu einem Kurzschluß führen kann.

Die JP 6-97350 (A) aus Patents Abstracts of Japan, E-1574 July 6, 1994, Vol. 18/No. 359 offenbart die elektrische Verbindung eines Halbleiterchips mit einem Leadframe, das ein keilförmiges Kontaktelement aufweist, auf das ein wedge-Kontakt aufgebracht wird, um eine bessere Führung des Bonddrahtes zu erreichen. Das keilförmige Kontaktelement ist jedoch ein aufwendig herzustellendes Einzelteil, das in einem speziellen Verfahrensschritt auf dem Leadframe angeordnet werden muß.

Die JP 4 294 552 A offenbart ein Bonddrahtherstellungsverfahren, bei dem zunächst eine Goldkugel auf eine Aluminiumkontaktfläche gequetscht ist, so dass während das Aufbringens eines Bonddrahtes auf die Goldkugel die Kapillare der Kontaktfläche nicht berührt werden.

Die JP 61 023 329 A offenbart ein Verfahren, bei dem ein Bonddraht verwendet wird, um auf einer Kontaktfläche einen Goldkontakthöcker zu bilden.

Die EP 0 320 244 A offenbart ein Substrat mit Kontakthöckern, wobei die Kontakthöcker aus einem in einer Schlinge geführten Bonddraht gebildet sind.

Die EP 0 211 360 offenbart eine Chipkarte, wobei ein Halbleiterchip über Bonndrähte mit einer Umverdrahtungsstruktur elektrisch verbunden wird.

Das Problem vorliegender Erfindung ist somit, ein Verfahren zum elektrischen Verbinden eines Halbleiterchips mit zumindest einer Kontaktfläche anzugeben, bei dem eine geeignete Führung des Bonddrahtes bei einfachem Montageverfahren gewährleistet ist.

Das Problem wird gelöst durch ein Verfahren gemäß Anspruch 1. Eine bevorzugte Weiterbildung der Erfindung ist in dem Anspruch 2 angegeben.

Durch das keilförmige Metallstück, das durch einen nailhead-Kontakt, dessen freies Ende in einer Schleife geführt und als wedge-Kontakt mit dem nailhead verbunden ist, gebildet wird, wird der loop des den Halbleiterchip mit der Kontaktfläche verbindenden Bonddrahts von der Oberfläche des Halbleiterchips in Richtung auf die Chipkante schräg nach oben geführt, so daß kein Kontakt mit der Kante zustande kommen kann.

Die Erfindung soll im folgenden anhand eines Ausführungsbeispiels mit Hilfe von Figuren näher beschrieben werden. Dabei zeigt
- Figur 1: in sechs aufeinanderfolgenden Bildern a bis f ein- zelne Verfahrensstadien zur Herstellung eines keilförmigen Metallstücks und
- Figur 2: in vier aufeinander folgenden Bildern a bis d die einzelnen Verfahrensstadien zur Herstellung einer Anordnung.

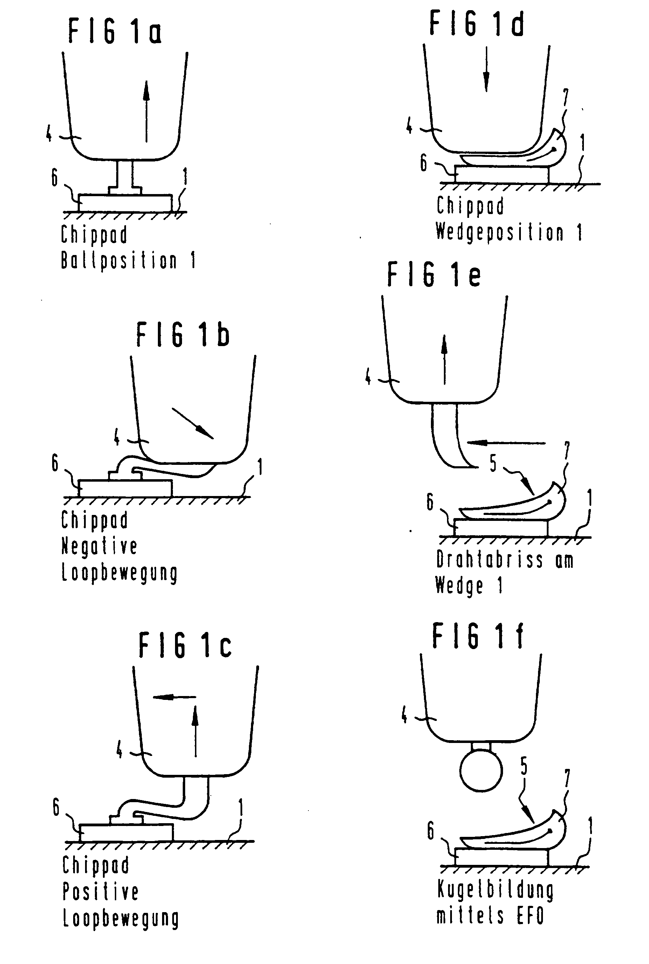

Gemäß Figur 1 wird ein Golddraht von etwa 24µm Durchmesser mittels einer Kapillare 4 auf ein dafür vorgesehenes Kontaktfeld auf einem Halbleiterchip 1 geführt. Am Ende der Kapillare hatte sich durch kurzzeitiges Verflüssigen des Golddrahtes eine Kugel, der sogenannte ball gebildet. Der Pfeil deutet die Bewegungsrichtung der Kapillare 4 an. Im Bild a wurde der ball auf das Kontaktfeld gedrückt und zu dem nailhead 6 geformt. Dazu wurde beispielsweise ein thermo-sonic-Verfahren angewendet. Danach bewegt sich, wie in den Bildern b bis d zu sehen ist, die Kapillare 4 mit dem Golddraht in einer Schleife und quetscht das freie Ende auf dem nailhead 6 ab wodurch die Schleife zu einem Keil 7 deformiert wird. Das Ende des Golddrahts wird danach wieder zu einem ball geschmolzen. Auf dem Kontaktfeld des Halbleiterchips 1 wurde auf diese Weise ein keilförmiges Metallstück 5 bestehend aus einem nailhead-Kontakt 6 und einer gequetschten Drahtschleife 7 ausgebildet.

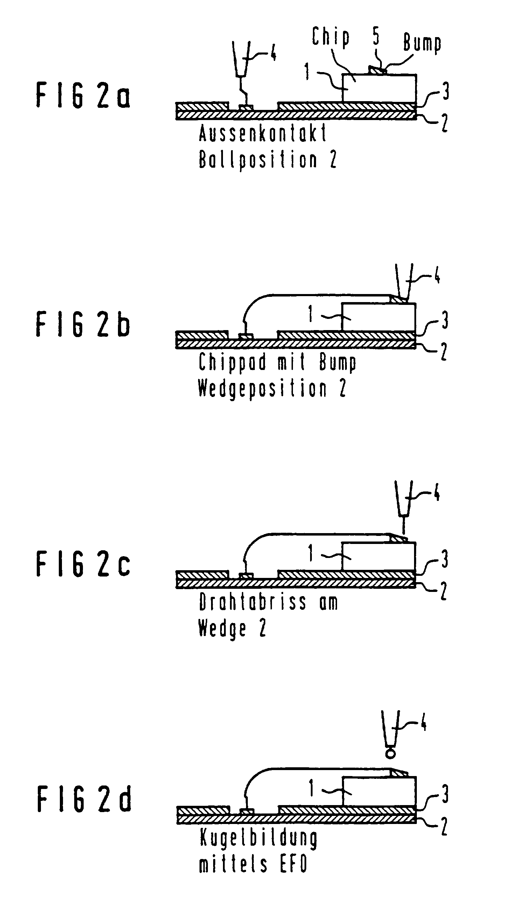

Die Figur 2 zeigt einen Ausschnitt aus einem Chipkartenmodul. Ein solcher Chipkartenmodul wird in eine Ausnehmung einer Plastikkarte eingesetzt, wodurch man eine Chipkarte erhält. Eine Glasepoxidplatte 3 ist einseitig mit einem Kupferlaminat 2 versehen und bildet einen Träger. In das Glasepoxid 3 des Trägers ist ein Loch für eine Kontaktfläche angebracht. Der Chip 1 ist auf das Glasepoxid 3 geklebt.

In Bild a ist gezeigt,daß der Golddraht mittels der Kapillare 4 auf der Kontaktfläche zu einem nailhead-Kontakt geformt wurde. Danach bewegt sich, wie in Bild b zu sehen ist, die Kapillare 4 mit dem Golddraht wieder zum Chip 1 hin und setzt auf dem keilförmigen Metallstück 5 auf dem Kontaktfeld des Chips 1 auf und quetscht dort den Golddraht ab. Danach wird die Kapillare 4 nach oben weggeführt, wie im Bild c angedeutet ist. Im Bild d ist schließlich zu sehen, daß auf dem sich auf dem Kontaktfeld der Halbleiterchipoberfläche befindenden nailhead-Kontakt der Golddraht mittels einer wedge-Verbindung aufgebracht ist und sich am Ende der Kapillare 4 bereits ein neuer ball gebildet hat. Aufgrund des keilförmigen Metallstücks, das gemäß Figur 1 mit einem nailhead-Kontakt und einer darauf angebrachten gequetschten Leiterschleife gebildet ist wird der Golddraht zur Verbindung des Halbleiterchips 1 mit einer Kontaktfläche zwar immer noch beinahe parallel zur Halbleiterchipoberfläche geführt, so daß der Golddrahts eine geringe loop-Höhe hat, durch die von der Chipoberfläche leicht ansteigende Führung des Drahtes ist jedoch die Gefahr einer Berührung des Drahtes mit der Chipkante beseitigt.

Im Vergleich mit dem Aluminium-Wedge-Bondverfahrenm, mit dem sich ebenfalls sehr geringe loop-Höhen erzeugen lassen, bietet dieses Verfahren den Vorteil, daß die Zeit für das Ziehen eines Drahtes wesentlich kürzer ist (etwa Faktor 2).

Das erfindungsgemäße Verfahren lässt sich natürlich in äquivalenter Weise auch bei anders aufgebauten Trägern für Chipkartenmodule und auch bei anderen Gehäusevarianten für Halbleiterbauelemente ver- bzw. anwenden.

## Patentansprüche

1. Verfahren zum Herstellen einer elektrischen Verbindung zwischen einem Halbleiterchip (1) und zumindest einer Kontaktfläche mittels eines dünnen Drahtes, dessen erstes Ende mit der zumindest einen Kontaktfläche und dessen zweites Ende mit einem auf einem Kontaktfeld des Halbleiterchips (1) angeordneten und mit diesem leitend verbundenen Metallstück (5) verschweißt ist, mit den folgenden Verfahrensschritten:
- Anbringen eines nailhead-Kontaktes auf einem Kontaktfeld des Halbleiterchips (1);
- Führen des freien Endes des nailhead-Kontakt-Drahtes in einer Schleife;
- Verbindung des in einer Schleife geführten freien Endes mit dem nailhead-Kontakt mittels eines wedge-Kontaktes, wobei ein keilförmiges Metallstück (5) gebildet wird;
- Bonden des ersten Endes eines dünnen Drahtes auf die Kontaktfläche mit einem nailhead-Kontakt;
- Bonden des zweiten Endes des dünnen Drahtes auf das keilförmige Metallstück (5), wobei durch das keilförmige Metallstück der loop des Bonddrahts von der Oberfläche des Halbleiterchips in Richtung auf die Chipkante schräg nach oben geführt wird.

2. Verfahren nach Anspruch 1, **dadurch gekennzeichnet, dass** der Halbleiterchip (1) und die zumindest eine Kontaktfläche auf einem gemeinsamen Träger (2, 3) angeordnet sind.

## Claims

1. Method for producing an electrical connection between a semiconductor chip (1) and at least one contact area by means of a thin wire, the first end of which is welded to the at least one contact area and the second end of which is welded to a metal piece (5) arranged on a contact zone of the semiconductor chip (1) and conductively connected to the latter, comprising the following method steps:
- fitting a nailhead contact on a contact zone of the semiconductor chip (1);
- guiding the free end of the nailhead contact wire in a loop;
- connecting the free end guided in a loop to the nailhead contact by means of a wedge contact, a wedge-shaped metal piece (5) being formed;
- bonding the first end of a thin wire onto the contact area with a nailhead contact;
- bonding the second end of the thin wire onto the wedge-shaped metal piece (5), in which case, by means of the wedge-shaped metal piece, the loop of the bonding wire is guided obliquely upwards from the surface of the semiconductor chip in the direction of the chip edge.

2. Method according to claim 1, **characterized in that** the semiconductor chip (1) and the at least one contact area are arranged on a common carrier (2, 3).

## Revendications

1. Procédé pour établir une liaison électrique entre une puce semi-conductrice (1) et au moins une surface de contact au moyen d'un mince fil dont la première extrémité est soudée à la ou aux surfaces de contact et la deuxième extrémité est soudée sur une pièce métallique (5) disposée sur une zone de contact de la puce semi-conductrice (1) et reliée de manière conductrice à cette dernière, le procédé présentant les étapes suivantes :
- placement d'un contact en tête de clou sur une zone de contact de la puce semi-conductrice (1);
- Guidage de l'extrémité libre du fil de contact en tête de clou en une boucle;
- liaison de l'extrémité libre guidée en boucle au contact en tête de clou au moyen d'un contact en biseau, formant une pièce métallique (5) en forme de biseau;
- liaison de la première extrémité d'un mince fil sur la surface de contact à l'aide d'un contact en tête de clou; et
- liaison de la deuxième extrémité du mince fil sur la pièce métallique (5) en forme de biseau, la pièce métallique en forme de biseau amenant la boucle du fil de liaison obliquement vers le haut en direction du bord de la puce depuis la surface de la puce semi-conductrice.

2. Procédé selon la revendication 1, **caractérisé en ce que** la puce semi-conductrice (1) et la ou les surfaces de contact sont disposées sur un support (2, 3) commun.
